(19) **Europäisches Patentamt / European Patent Office / Office européen des brevets**

(11) **EP 3 232 215 B1**

(12) **EUROPEAN PATENT SPECIFICATION**

(45) Date of publication and mention
of the grant of the patent:
**25.05.2022  Bulletin 2022/21**

(21) Application number: **15867229.5**

(22) Date of filing: **31.03.2015**

(51) International Patent Classification (IPC):
**G01R 31/34** *(2020.01)*     **H02P 23/00** *(2016.01)*

(52) Cooperative Patent Classification (CPC):
**G01R 31/343; H02P 23/00**

(86) International application number:
**PCT/JP2015/060055**

(87) International publication number:
**WO 2016/092871 (16.06.2016 Gazette 2016/24)**

(54) **ELECTRIC MOTOR DIAGNOSIS DEVICE**

ELEKTROMOTORDIAGNOSEVORRICHTUNG

DISPOSITIF DE DIAGNOSTIC DE MOTEUR ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **10.12.2014   JP 2014249621**

(43) Date of publication of application:
**18.10.2017   Bulletin 2017/42**

(73) Proprietor: **Mitsubishi Electric Corporation**
**Chiyoda-ku**
**Tokyo 100-8310 (JP)**

(72) Inventors:
• **MIYAUCHI Toshihiko**
  **Tokyo 100-8310 (JP)**
• **KANEMARU Makoto**
  **Tokyo 100-8310 (JP)**
• **MORI Mitsugi**
  **Tokyo 100-8310 (JP)**
• **TSUKIMA Mitsuru**
  **Tokyo 100-8310 (JP)**

(74) Representative: **Sajda, Wolf E.**
**Meissner Bolte Patentanwälte**
**Rechtsanwälte Partnerschaft mbB**
**Postfach 86 06 24**
**81633 München (DE)**

(56) References cited:
WO-A1-2014/156386     WO-A1-2014/156386
JP-A- 2014 117 141     US-A- 5 477 163
US-A- 5 514 978        US-A- 5 786 708
US-A1- 2014 117 912

• SOTTILE J ET AL: "AN ON-LINE METHOD TO DETECT INCIPIENT FAILURE OF TURN INSULATION INRANDOM-WOUND MOTORS", IEEE TRANSACTIONS ON ENERGY CONVERSION, IEEE SERVICE CENTER, PISCATAWAY, NJ, US, vol. 8, no. 4, 31 December 1993 (1993-12-31), pages 762-768, XP000423898, ISSN: 0885-8969, DOI: 10.1109/60.260992
• RANGARAJAN M TALLAM ET AL: "Transient Model for Induction Machines With Stator Winding Turn Faults", IEEE TRANSACTIONS ON INDUSTRY APPLICATIONS, IEEE SERVICE CENTER, PISCATAWAY, NJ, US, vol. 38, no. 3, 31 May 2002 (2002-05-31), XP011073475, ISSN: 0093-9994

**Description**

TECHNICAL FIELD

The present invention relates to an electric motor diagnosis device which monitors the state of an electric motor and protects the electric motor against becoming an abnormal state.

BACKGROUND ART

A lot of electric motors exist in a plant, and diagnosis of such a facility is performed by a maintenance department through five-sense diagnosis. A diagnosis for an electric motor, which is particularly important, needs to be regularly performed, so that the cost therefor becomes high. In addition, once deterioration of an electric motor starts, progress of the deterioration is accelerated.

In some AC machines, a void or a damaged portion in an insulation material caused by mechanical stress and thermal deterioration induces a layer short-circuit (an interlayer short-circuit) due to discharges or the like, and suddenly causes an insulation breakdown. Thus, once an electric motor is deteriorated, only the progress of deterioration follows.

Accordingly, concern for a technique of continuously monitoring electric motors has increased. However, continuous monitoring of electric motors is, in most cases, based on the premise that various measurement devices such as sensors are attached to each of the electric motors. Examples of such measurement devices include a torque meter, an encoder, and an acceleration sensor.

However, application of such a premise to a motor control center that centrally controls several hundreds to several thousands of motors increases the number of wires, and thus, such application is not realistic. For this reason, a device is required which improves reliability, productivity, and safety while simply diagnosing the states of electric motors on the basis of information on currents and voltages measured by a motor control center without using a special sensor.

For example, there has been technology in which, even when the capacity or load of an electric motor varies, a steady-state current setting circuit adjusts a current at a steady-state operation time to use the current as a reference, a pulsation signal value and upper and lower limits of an allowable variation range are set with respect to the reference, a load current of the electric motor is continuously monitored, and thereby an abnormal operation state of the electric motor is monitored (see Patent Document 1).

In addition, a quality diagnosis system for electric motors has been known which comprises:

characteristic amount detection means that detects characteristic amounts from a current flowing through an electric motor to be diagnosed;
calculation storage means that derives and stores the average and standard deviation of the characteristic amounts obtained, when the electric motor is in a normal state, by the characteristic amount detection means; and
diagnosis means that calculates stochastic distribution on the basis of the characteristic amounts obtained by the characteristic amount detection means and the average and standard deviation of the characteristic amounts stored in the calculation storage means, to perform diagnosis as to whether the electric motor is normal or abnormal (see Patent Document 2).

Moreover, a short-circuit diagnosis system for electric motor stator windings has been known which comprises:

a detection unit that detects a voltage supplied from a power source to an electric motor to be diagnosed and a current flowing through a stator winding of the electric motor; and
a determination unit that determines that the stator winding is short-circuited when a current value after elapse of a predetermined time from a time at which the voltage detected by the detection unit becomes zero is greater than a threshold which is set in advance by considering whether the stator winding is in a normal state or in a short-circuit state where a current phase advances due to reduction in inductance component (see Patent Document 3).

Another example of prior art is WO 2014/156386 A1 which discloses an electric motor diagnosis device where each electric motor has a zero-phase current detector, a phase current detector, and a phase voltage detector attached thereto, and four different types of electric motor abnormalities are detected using only voltage and current analysis.

Another further example of prior art is US 5 477 163 A which discloses a method for detecting turn faults in an induction motor whereby the motor torque is estimated by employing the at least two motor phase currents and the at least two motor phase voltages and is further used to estimate the load variation effect on the negative sequence impedance. The negative sequence impedance is adjusted in accordance with the load variation effect, and it is determined whether the adjusted negative sequence impedance value indicates the presence of a turn fault.

LIST OF CITATIONS

PATENT DOCUMENTS

Patent Document 1: Japanese Laid-Open Patent Publication JP 62-218 883 A
Patent Document 2: Japanese Laid-Open Patent Publication JP 2012-220 485 A
Patent Document 3: Japanese Examined Patent Publication JP 4 367 784 B2.

SUMMARY OF THE INVENTION

PROBLEMS TO BE SOLVED BY THE INVENTION

In the above short-circuit diagnosis device for electric motor stator windings, calculation parameters are influenced by load torque variation, power source imbalance, and contact failure malfunction. As a result, a problem has been raised in that there is a difficulty in correctly and highly accurately detecting a winding short-circuit malfunction.
Further, if load torque variation, power source imbalance, contact failure malfunction, and winding short-circuit malfunction have occurred simultaneously, detecting only the winding short-circuit malfunction is difficult and there is a possibility of erroneous detection.
The present invention has been made to solve the above problems, and an object of the present invention is to provide an electric motor diagnosis device for detecting only short-circuit malfunction in a stator winding of an electric motor, on the basis of information on a voltage and a current obtained online during operation of the electric motor, without being influenced by load torque variation, power source imbalance, or contact failure malfunction.

SOLUTION TO THE PROBLEMS

According to an aspect of the invention, an electric motor diagnosis device is defined by the claim 1.

EFFECT OF THE INVENTION

According to the present invention, even when a winding short-circuit and voltage imbalance occur simultaneously in an electric motor in which load torque variation occurs during operation, only the winding short-circuit can be detected, without causing erroneous detection, by calculating a reverse-phase admittance characteristic, a reverse-phase/positive-phase current characteristic, and a voltage imbalance rate.
The present invention provides an unprecedented remarkable effect of not causing erroneous detection of either power source imbalance, which causes voltage imbalance, or contact failure malfunction in a power source line.

BRIEF DESCRIPTION OF THE DRAWINGS

FIG. 1     is a circuit configuration diagram of an electric motor diagnosis device according to a first embodiment of the present invention.
FIG. 2     is a conceptual diagram of winding short-circuit malfunction to be diagnosed in the present invention.
FIG. 3     is a diagram illustrating an internal configuration of a logical calculation unit of the electric motor diagnosis device according to the first embodiment of the present invention.
FIG. 4     is a diagram showing a relationship between a positive-phase current and a reverse-phase admittance according to the first embodiment of the present invention.
FIG. 5     is a diagram showing a relationship between a reverse-phase current and a positive-phase current according to the first embodiment of the present invention.
FIG. 6     is a diagram showing evaluation values for respective malfunction cases according to the first embodiment of the present invention.
FIG. 7     is a flowchart illustrating a winding short-circuit malfunction detection algorithm according to the first embodiment of the present invention.
FIG. 8     is a flowchart illustrating a winding short-circuit malfunction detection algorithm according to a second embodiment of the present invention.
FIG. 9     is a circuit configuration diagram of an electric motor diagnosis device according to a fourth embodiment of the present invention.

FIG. 10   is a diagram illustrating the internal configuration of a logical calculation unit of the electric motor diagnosis device according to the fourth embodiment of the present invention.

FIG. 11   is a flowchart illustrating winding short-circuit malfunction detection algorithm according to the fourth embodiment of the present invention.

DESCRIPTION OF EMBODIMENTS

First Embodiment.

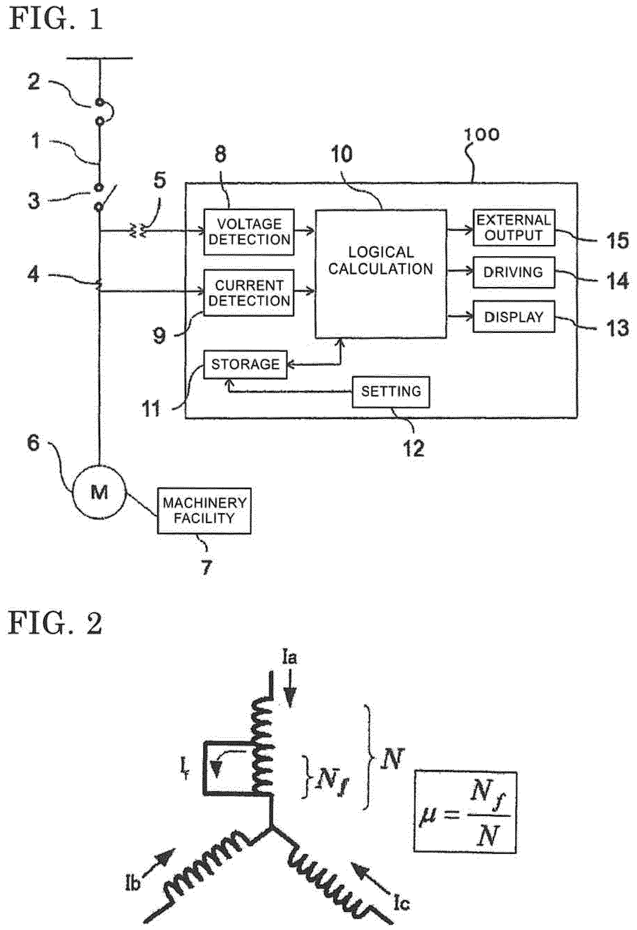

Hereinafter, an electric motor diagnosis device according to a first embodiment of the present invention is described with reference to FIGS. 1 to 7.

FIG. 1 is a configuration circuit diagram of the electric motor diagnosis device according to the first embodiment of the present invention, which is used in a control center which is mainly an enclosed switchboard.

In FIG. 1, a main circuit 1 of a power source drawn from a power system comprises a wiring disconnector 2, an electromagnetic contactor 3, an instrument current transformer 4 which detects a load current of the main circuit 1, and an instrument voltage transformer 5 which detects the voltage of the main circuit 1. Further, the main circuit 1 is connected to an electric motor 6 which is a load, and the electric motor 6 drives a machinery facility 7 to operate.

An electric motor diagnosis device 100 comprises a voltage detection circuit 8 connected to the instrument voltage transformer 5, a current detection circuit 9 connected to the instrument current transformer 4, a logical calculation circuit (logical calculation unit) 10, a storage circuit 11, and a setting circuit 12.

The voltage detection circuit 8 detects a line voltage of the main circuit 1 of the power source connected to the electric motor, and converts a phase voltage of the electric motor or the magnitude thereof to a predetermined signal to detect the voltage of the electric motor, and outputs the voltage to the logical calculation circuit 10 and the storage circuit 11.

The current detection circuit 9 detects the load current of the main circuit 1 of the power source connected to the electric motor, converts a phase current of the electric motor or the magnitude thereof to a predetermined signal to detect the current of the electric motor, and outputs the current to the logical calculation circuit 10 and the storage circuit 11.

The logical calculation circuit 10 receives outputs from the voltage detection circuit 8 and the current detection circuit 9, calculates a reverse-phase current, a positive-phase voltage, a positive-phase current, a reverse-phase admittance, and the like by analyzing the voltage and current of the electric motor, and determines and detects a winding short-circuit by distinguishes the winding short-circuit from power source imbalance and contact failure, even when the load torque varies during operation of the electric motor.

The setting circuit 12 connected to the storage circuit 11 has a set key, and causes, when the set key is pressed (long-pressed, for example), the storage circuit 11 to store and hold initial normal-state data. Data before release of the set key can be stored.

A display circuit (display unit) 13 connected to the logical calculation circuit 10 displays an abnormal state or a warning, etc. when an abnormality of the load current is detected or an abnormality of the electric motor 6 is detected by the logical calculation circuit 10.

A driving circuit 14 connected to the logical calculation circuit 10 causes the electromagnetic contactor 3 to open/close in accordance with an output as a result of calculation of a current detection signal from the instrument current transformer 4. An external output circuit (external output unit) 15 outputs an abnormal state or a warning, etc. from the logical calculation circuit 10 to the outside.

FIG. 2 illustrates an image of winding short-circuit malfunction to be diagnosed here. In the stator winding of the electric motor 6, both a same-layer short circuit and an inter-layer short circuit may occur. When the number of short-circuited turns is Nf, a short-circuit rate is generalized and represented by $\mu$ = Nf/N using the ratio with respect to the number of total turns N.

In the present invention, rated information about the electric motor 6 is not necessary to be inputted before operation starts.

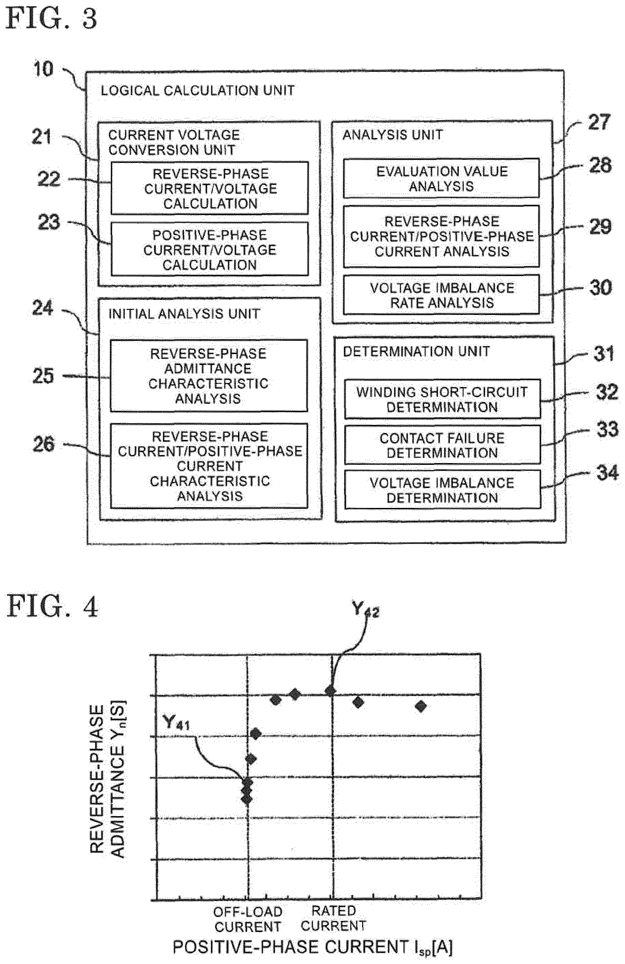

FIG. 3 is an internal configuration diagram of the logical calculation circuit 10 which performs detection and determination of a short-circuit in the stator winding of the electric motor 6. The logical calculation circuit 10 comprises a current voltage conversion unit 21, an initial analysis unit 24, an analysis unit 27, and a determination unit 31.

The current voltage conversion unit 21 comprises a reverse-phase current/reverse-phase voltage calculation unit 22 and a positive-phase current/positive-phase voltage calculation unit 23, and converts three phase voltages and currents detected by the voltage detection circuit 8 and the current detection circuit 9, to a reverse-phase current Isn and a reverse-phase voltage Vsn, and a positive-phase current Isp and a positive-phase voltage Vsp, by symmetrical coordinate conversion processing using Expressions (1) to (4).

[Expression 1]
Expression 1

$$Isp = \frac{1}{3}(Iu + a\,Iv + a^2\,Iw) \quad \cdots (1)$$

$$Isn = \frac{1}{3}(Iu + a^2\,Iv + a\,Iw) \quad \cdots (2)$$

$$Vsp = \frac{1}{3}(Vu + a\,Vv + a^2\,Vw) \quad \cdots (3)$$

$$Vsn = \frac{1}{3}(Vu + a^2\,Vv + a\,Vw) \quad \cdots (4)$$

where,

$$a = e^{j\frac{2}{3}\pi}$$

In the Expression, Isp represents a normal-phase current, Isn represents a reverse-phase current, Iu represents a U-phase current, Iv represents a V-phase current, Iw represents a W-phase current, Vsp represents a positive-phase voltage, Vsn represents a reverse-phase voltage, Vu represents a U-phase voltage, Vv represents a V-phase voltage, and Vw represents a W-phase voltage. Alternatively, a method for obtaining a positive-phase voltage and a reverse-phase voltage not from phase voltages but from a line voltage may be used.

The initial analysis unit 24 comprises a reverse-phase admittance characteristic analysis unit 25 for a normal state and a reverse-phase current/positive-phase current characteristic analysis unit 26.

The reverse-phase admittance characteristic analysis unit 25 causes a normal time reverse-phase admittance value Yn to be stored before determination of a winding short-circuit. The reverse-phase admittance Yn is varied by slip. That is, the value of the reverse-phase admittance Yn varies depending on the magnitude of the load torque.

To establish a determination method independent of the load torque, a reverse admittance characteristic with respect to a normal-time positive-phase current value is stored. A preferable timing for the storage is a time at which the electric motor is started because data of reverse-phase admittances from an off-load time to an on-load time can be acquired.

FIG. 4 is a graph showing the characteristics of the reverse-phase admittance Yn relative to change in the positive-phase current Isp. A reverse-phase admittance value Y41 at an off-load current time is low, and a reverse-phase admittance value Y42 at an on-load time is great. Since an amount of data to be stored is preferably small in order to reduce a processing memory amount, the value of a reverse-phase admittance at a point where data cannot be acquired is determined by complementing the value through approximate curve processing, for example.

The value of the reverse-phase admittance Yn is varied by load torque variation. At least a reverse-phase admittance value within an estimated torque range during a normal operation needs to be stored.

The reverse-phase current/positive-phase current characteristic analysis unit 26 is implemented in order to perform determination of a contact failure. Here, expected contact failures include deterioration in a cable, a screw fastening portion for connecting the electric motor 6 to a power source cable (the main circuit 1), or other portions having screws.

For an increase amount, of the reverse-phase current Isn relative to the positive-phase current Isp, to be used for evaluation in determination of a winding short-circuit, a threshold is determined using a least-squares method, or the like on the basis of the normal time data. Here, unless the positive-phase current Isp varies, the increase amount cannot be calculated.

Usually, a torque is always generated in a load facility, and thus no problem may be raised. A winding short-circuit determination method is changed depending on an increase value of the reverse-phase current Isn relative to the positive-phase current Isp. When a resistive component exists due to a contact failure, the increase value of the reverse-phase current Isn relative to the positive-phase current Isp increases.

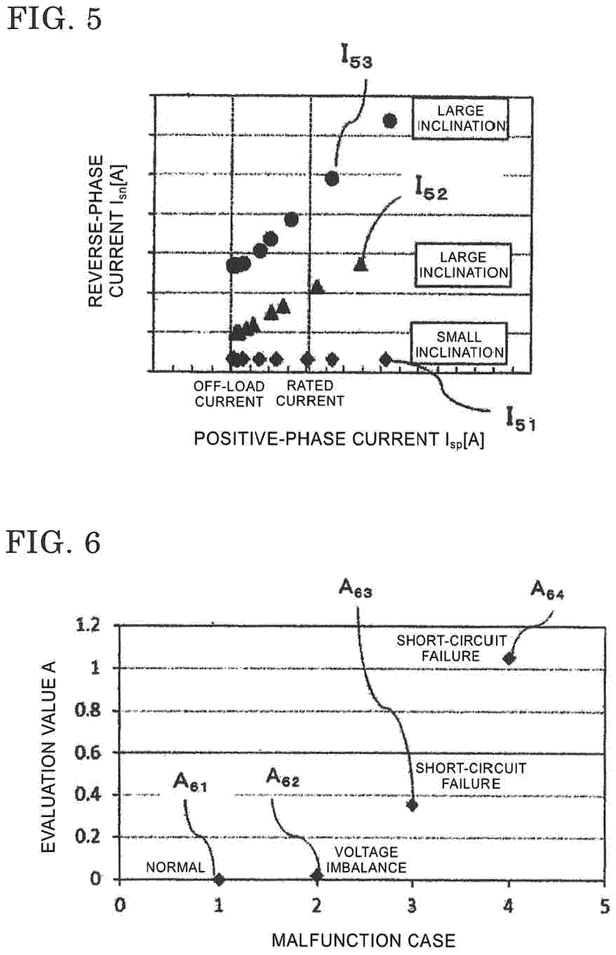

FIG. 5 is a graph showing the characteristics of the positive-phase current Isp and the reverse-phase current Isn. A characteristic 151 in a case where no contact failure occurs shows that an increase amount of the reverse-phase current Isn relative to the positive-phase current Isp is small and the inclination thereof is small.

On the other hand, a characteristic 152 and a characteristic 153 in cases where contact failures occur each show that an increase amount of the reverse-phase current Isn relative to the positive-phase current Isp is large, and the inclination thereof is large.

The contact resistance of the characteristic 153 is greater than that of the characteristic 152. A threshold δ2 for performing determination of a contact failure is determined in advance on the basis of a normal time result (for example, the characteristic 151).

The analysis unit 27 comprises an evaluation value analysis unit 28, a reverse-phase current/positive-phase current analysis unit 29, and a voltage imbalance rate analysis unit 30, and performs analysis for determination performed by a winding short-circuit determination unit 32, a contact failure determination unit 33, and a voltage imbalance determination unit 34 in the determination unit 31.

The evaluation value analysis unit 28 calculates an evaluation value A= |Isn-Yn*Vsn|.

Calculation of the evaluation value A will be described. Currents (Iu, Iv, Iw) and voltages (Vuv, Vvw, Vwu) are updated by the voltage detection circuit 8 and the current detection circuit 9. A winding short-circuit is a phenomenon of short-circuit occurring between coil wires. Since three-phase stator currents become asymmetric when a winding short-circuit occurs, the winding short-circuit can be detected from the reverse-phase component.

When a short-circuit rate in a case where a part of a stator winding of a three-phase induction motor is $\mu$ (= Nf/N, Nf turns of the number N of turns of each phase are short circuited), the following relational expressions are obtained between the positive-phase voltage Vsp and the reverse-phase voltage Vsn, and between the positive-phase current Isp and the reverse-phase current Isn, wherein $\mu$<<1 is assumed.

[Expression 2]
Expression 2

$$
\begin{pmatrix} I\,s\,p \\ I\,s\,n \end{pmatrix} = \begin{pmatrix} Y\,p & Y\,p\,n \\ Y\,p\,n & Y\,n \end{pmatrix} \begin{pmatrix} V\,s\,p \\ V\,s\,n \end{pmatrix} \qquad \cdots (5)
$$

$$
Y\,p\,n = \frac{\mu^2}{3\,(j\,\mu\,\omega\,L\,s + r_f + \mu\,r_s)} \qquad \cdots (6)
$$

$$
Y\,p = Y\,n = \frac{j\mu\,\omega Lr + r_r}{s\omega^2 Lm^2 - (s\omega Lr - jr_r)(\omega Ls - jr_s)} - \frac{\mu^2}{3(j\mu\,\omega Ls + r_f + \mu\,r_s)} \qquad \cdots (7)
$$

In the Expression, Yp, Yn, Ypn each represent an admittance, $\omega$ represents a power source angular velocity, rs represents a stator resistance, rr represents a rotor resistance, rf represents a short-circuit resistance, Ls represents a stator leak inductance, Lr represents a rotor leak inductance, Lm represents an excitation inductance, and $\mu$ represents a short-circuit rate.

A non-diagonal component Ypn of the admittance Y can be an index of a winding short-circuit, but the non-diagonal component Ypn cannot be easily calculated in an actual field. Here, a method of monitoring both the reverse-phase current Isn and the reverse-phase voltage Vsn is used. When a winding short-circuit does not occur ($\mu$ = 0), the non-diagonal component Ypn of the admittance Y is zero, and thus,

$$
Isn = Yn \cdot Vsn \dots (8)
$$

is established. When a winding short-circuit occurs,

$$
Isn = Yn \cdot Vsn + Ypn \cdot Vsp \dots (9)
$$

is established so that Isn varies. When both Isn and Vsn are monitored and

$$
\text{Evaluation value } A = |Isn - Yn \cdot Vsn| \dots (10)
$$

is used as an index, occurrence of a winding short-circuit is considered to be distinguishable from occurrence of power source voltage imbalance (change in Vsn). At the beginning of introduction, determination of a winding short-circuit is performed by monitoring the evaluation value A represented by the Expression (10) after performing initialization (calculation of Yn) while assuming that no winding short-circuit has yet occurred.

FIG. 6 is a diagram showing the relationship of the evaluation value A to each malfunction case. Regarding an evaluation value A61 at a normal time and an evaluation value A62 at a time of voltage imbalance, the evaluation value A is small. Regarding evaluation values A63, A64 in a case where short-circuit occurs, the evaluation value A is large.

Accordingly, a threshold $\delta 1$ of the evaluation value A is set between the evaluation value A62 and the evaluation value A63, so that winding short-circuit malfunction can be detected distinguishably from voltage imbalance.

For the reverse-phase admittance Yn, data calculated by the reverse-phase admittance characteristic analysis unit 25 is used. In evaluation value analysis performed by the evaluation value analysis unit 28, reverse-phase admittance values of the positive-phase currents are assigned, so that the evaluation value can be analyzed.

The reverse-phase current/positive-phase current analysis unit 29 analyzes the increase amount of the reverse-phase current Isn relative to the positive-phase current Isp. Before determination, a normal-time increase amount, of a reverse-phase current/positive-phase current characteristic analyzed by the reverse-phase current/positive-phase current characteristic analysis unit 26 is stored, and a threshold $\delta 2$ is determined by statistical processing, in advance.

The reverse-phase current/positive-phase current analysis unit 29 analyzes the increase amount of the reverse-phase current Isn relative to the positive-phase current Isp, to distinguish a winding short-circuit and a contact failure in the electric motor 6 from each other on the basis of whether the increase amount is greater or less than the threshold $\delta 2$.

The voltage imbalance rate analysis unit 30 calculates a voltage imbalance rate from phase voltages of the respective phases or a line voltage.

For example, when a voltage imbalance rate Vunbal is obtained from a line voltage, the following expression is used.

$$\text{Voltage imbalance rate} = ((\text{maximum difference between line voltage and average voltage})/\text{average voltage}) \times 100 \ \%$$

That is, the maximum value among

$$(\text{Vuv} - \text{Vavg})/\text{Vavg} \times 100 \ \%,$$

$$(\text{Vvw} - \text{Vavg})/\text{Vavg} \times 100 \ \%,$$

and

$$(\text{Vwu} - \text{Vavg})/\text{Vavg} \times 100 \ \%,$$

wherein,

$$\text{average voltage Vavg} = (\text{Vuv} + \text{Vvw} + \text{Vwu})/3.$$

In the determination unit 31, analysis results calculated by the analysis unit 27 are compared with the thresholds $\delta 1$, $\delta 2$ or the like, and thereby the winding short-circuit determination unit 32 performs determination of a winding short-circuit, the contact failure determination unit 33 performs determination of a contact failure, and the voltage imbalance determination unit 34 performs determination of voltage imbalance. The determination results are sent to the display circuit 13, the driving circuit 14, and the external output circuit 15 illustrated in FIG. 1.

When an abnormality such as a winding short-circuit or contact failure in the electric motor 6 is detected, the display circuit 13 displays an abnormality state or a warning, etc. When an abnormality in the electric motor 6 is detected, the driving circuit 14 causes the electromagnetic contactor 3 to open/close. The external output circuit (external output unit) 15 outputs the abnormality state or the warning, etc. in the electric motor 6 to the outside.

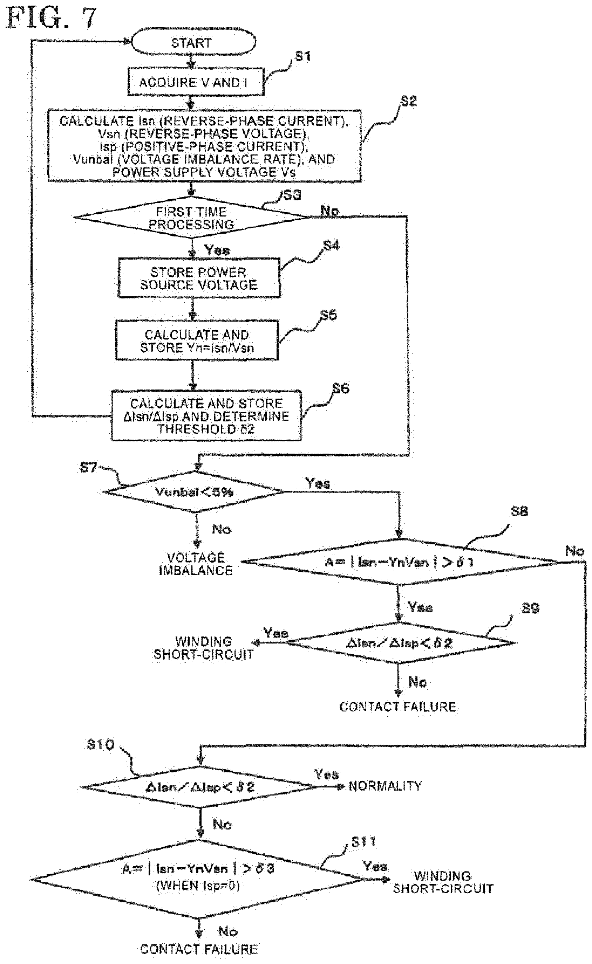

Next, a diagnosis processing in the electric motor diagnosis device will be described with reference to the flowchart in FIG. 7. At step S1, a voltage (a line voltage or a phase voltage) V and a current (a phase current) I of the electric motor are acquired. At step S2, the reverse-phase current Isn, the reverse-phase voltage Vsn, the positive-phase current Isp, the voltage imbalance rate Vunbal, a power source voltage Vs are calculated.

At step S3, first time determination is performed. In the case of a first time processing (YES), the processing proceeds to step S4 and the power source voltage Vs is stored. Calculation of the power source voltage Vs at step S2 and storage of the power source voltage Vs at step S4 may be omitted.

At step S5, the reverse-phase admittance Yn is calculated from the reverse-phase current/reverse-phase voltage characteristic, and the positive-phase current characteristic of the reverse-phase admittance Yn is stored.

At step S6, the increase amount AIsn/AIsp of the reverse-phase current Isn relative to the positive-phase current Isp is calculated from the reverse-phase current/reverse-phase voltage characteristic, and the threshold $\delta 2$ of the increase amount is set. After that, the processing returns to START.

In the case of not being a first time processing at step S3 (NO), the processing proceeds to step S7 and the voltage imbalance rate Vunbal is compared with a threshold of 5 %. The threshold is not limited to 5 %, and may be set to a predetermined value at which voltage imbalance is considered to occur. At step S7, when the voltage imbalance rate Vunbal is equal to or greater than the threshold of 5 % (NO), occurrence of voltage imbalance is displayed.

On the other hand, when the voltage imbalance rate Vunbal is less than the threshold of 5 % (YES), the processing proceeds to step S8. At step S8, the evaluation value $A=|Isn-Yn*Vsn|$ is compared with the threshold $\delta 1$. When the evaluation value A is equal to or greater than the threshold $\delta 1$ (YES), the processing proceeds to step S9 and the increase amount $\triangle Isn/\triangle Isp$ of the reverse-phase current Isn relative to the positive-phase current Isp is compared with the threshold $\delta 2$.

When the reverse-phase current $\triangle Isn/$the positive-phase current $\triangle Isp$ is less than the threshold $\delta 2$ at step S9 (YES), a winding short-circuit is determined. When the reverse-phase current $\triangle Isn/$the positive-phase current $\triangle Isp$ is equal to or greater than the threshold $\delta 2$ (NO), a contact failure is determined.

When the evaluation value A is less than the threshold $\delta 1$ at step S8 (NO), the processing proceeds to step S10 and the increase amount $\triangle Isn/\triangle Isp$ of the reverse-phase current Isn relative to the positive-phase current Isp is compared with the threshold $\delta 2$.

When the increase amount of the reverse-phase current Isn relative to the positive-phase current Isp is less than the threshold $\delta 2$ at step S10 (YES), normality is determined. When the increase amount $\triangle Isn/\triangle Isp$ of the reverse-phase current Isn relative to the positive-phase current Isp is equal to or greater than the threshold $\delta 2$ (NO), the processing proceeds to step S11.

At step S11, the characteristic of the evaluation value A with respect to the positive-phase current Isp is calculated, the positive-phase current Isp is approximated to 0A to obtain an intercept (the intercept being obtained from a plurality of measured plots through a least-squares method), and the obtained value is compared with a threshold $\delta 3$.

The threshold $\delta 3$ is slightly less than the threshold $\delta 1$. When the evaluation value A is equal to or greater than the threshold $\delta 3$ at step S11 (YES), a winding short-circuit is determined. When the evaluation value A is less than the threshold $\delta 3$ (NO), a contact failure is determined.

As described above, in the first embodiment, determination of an abnormality state of the electric motor is performed on the basis of a reverse-phase current, a reverse-phase voltage, a positive-phase current, and a reverse-phase admittance obtained by analysis of the voltage and the current of the electric motor.

Accordingly, even when a load torque varies during operation of the electric motor, it is possible to determine and detect a winding short-circuit while distinguishing the winding short-circuit from voltage imbalance. In addition, even when a contact failure occurs in the power source line, a winding short-circuit in the electric motor can be determined.

Second Embodiment.

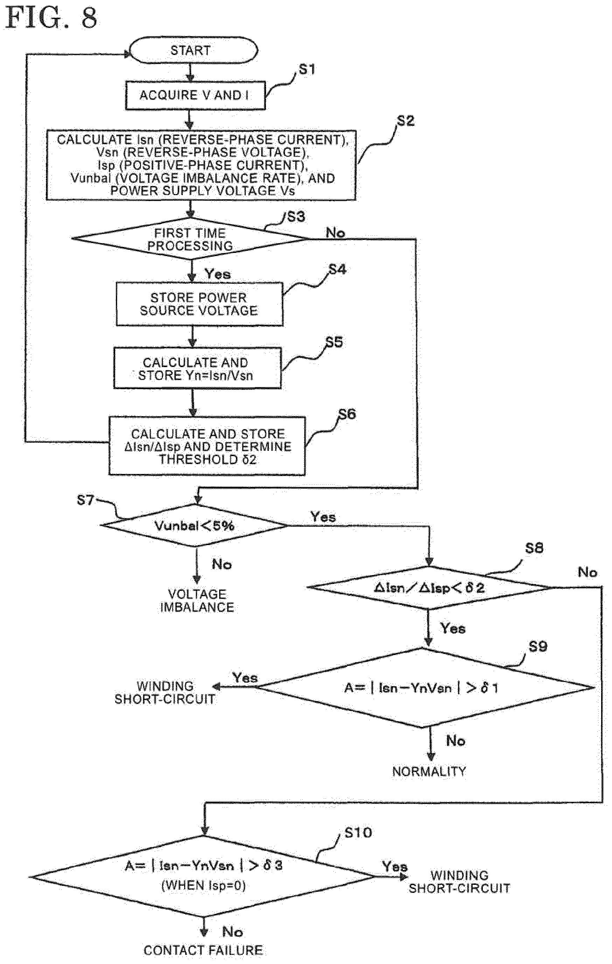

Next, an electric motor diagnosis device according to a second embodiment of the present invention is described with reference to FIG. 8.

FIG. 8 is a flowchart illustrating a diagnosis processing according to the second embodiment. Steps S1 to S7 are identical to those in the first embodiment, and the explanation thereof is omitted.

In FIG. 8, at step S8, the increase amount of the reverse-phase current Isn relative to the positive-phase current Isp is compared with the threshold $\delta 2$. When the increase amount of the reverse-phase current Isn relative to the positive-phase current Isp is less than the threshold $\delta 2$ at step S8 (YES), the processing proceeds to step S9.

At step S9, the evaluation value $A=|Isn-Yn*Vsn|$ is compared with the threshold $\delta 1$. When the evaluation value A is equal to or greater than the threshold $\delta 1$ (YES), a winding short-circuit is determined. When the evaluation value A is less than the threshold $\delta 1$ (NO), normality is determined.

When the increase amount of the reverse-phase current Isn relative to the positive-phase current Isp is equal to or greater than the threshold $\delta 2$ at step S8 (NO), the processing proceeds to step S10.

At step S10, the characteristic of the evaluation value A with respect to the positive-phase current Isp is calculated, the positive-phase current Isp is approximated to 0A to obtain an intercept (the intercept being obtained from a plurality of measured plots through a least-squares method), and the obtained value is compared with the threshold $\delta 3$.

When the value is equal to or greater than the threshold $\delta3$ (YES), a winding short-circuit is determined. When the value is less than the threshold $\delta3$ (NO), a contact failure is determined.

As described above, in the second embodiment, determination of an abnormal state of the electric motor is performed, as in the first embodiment, on the basis of a reverse-phase current, a reverse-phase voltage, a positive-phase current, and a reverse-phase admittance obtained by analysis of the voltage and the current of the electric motor.

Although the determination method is modified from that in the first embodiment, it is still possible to determine and detect a winding short-circuit even when a load torque varies during operation of the electric motor. In addition, even when a contact failure occurs in the power source line, a winding short-circuit in the electric motor can be determined.

Third Embodiment.

Next, an electric motor diagnosis device according to a third embodiment of the present invention will be described.

In the first and second embodiments, one logical calculation unit 10 is provided for each electric motor 6. In the third embodiment, one logical calculation unit 10 performs abnormality determination on a plurality of electric motors by analyzing voltage and current signals.

In the first embodiment, an abnormal value is stored at a first time processing if an electric motor already has had a failure at first time storage of a normal value, which is a drawback of the embodiment.

Accordingly, information about a plurality of electric motors is processed collectively so that determination of normality/abnormality can be performed at first time determination in the case of the same electric motors, for example.

Fourth Embodiment.

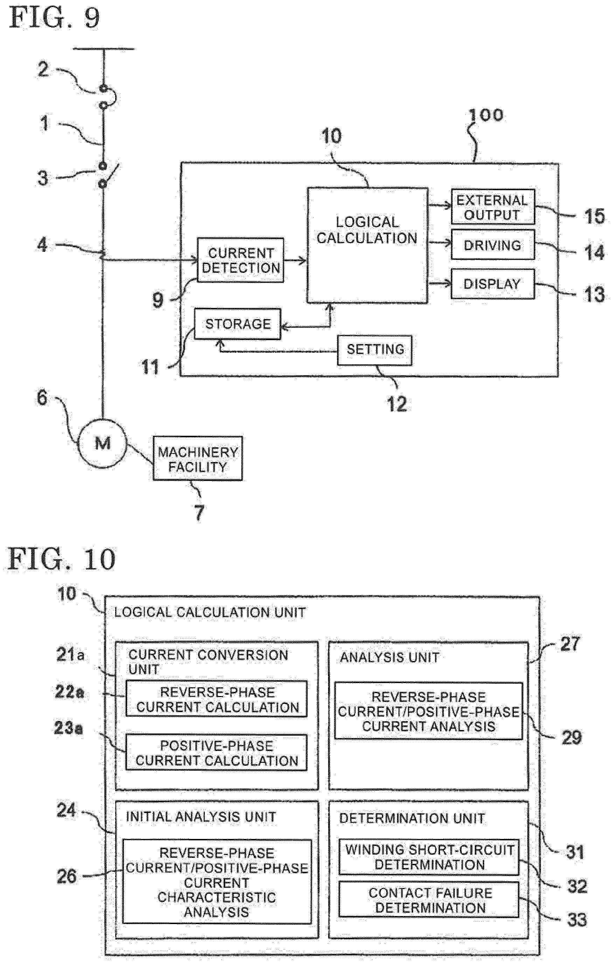

Next, an electric motor diagnosis device according to a fourth embodiment of the present invention will be described with reference to FIG. 9 to 11.

In the first embodiment, diagnosis determination using the current and voltage of the electric motor is performed. The fourth embodiment uses a method of determining a winding short-circuit by using only the current of the electric motor. FIG. 9 is a configuration circuit diagram illustrating the electric motor diagnosis device according to the fourth embodiment of the present invention.

The configuration is obtained by eliminating the instrument voltage transformer 5 and the voltage detection circuit 8 from the configuration in FIG. 1. In FIG. 9, components identical or equivalent to those in FIG. 1 are denoted by the same reference numerals, and the explanation thereof is omitted.

FIG. 10 is an internal configuration diagram of the logical calculation circuit 10 that detects and determines a short-circuit in the stator winding of the electric motor 6. In FIG. 10, components identical or equivalent to those in FIG. 3 are denoted by the same reference numerals.

In FIG. 10, the logical calculation circuit 10 comprises a current conversion unit 21a, an initial analysis unit 24, the analysis unit 27, and the determination unit 31.

The current conversion unit 21a comprises a reverse-phase current calculation unit 22a and a positive-phase current calculation unit 23a, and performs conversion to the reverse-phase current Isn and the positive-phase current Isp through symmetrical coordinate conversion processing using the Expressions (1) and (2).

The initial analysis unit 24 comprises the reverse-phase current/positive-phase current characteristic analysis unit 26 that performs reverse-phase current/positive-phase current characteristic analysis, and performs determination of a contact failure.

When a resistive component exists due to a contact failure, an increase amount of the reverse-phase current Isn relative to the positive-phase current Isp increases. The threshold $\delta2$ for performing contact failure determination is determined in advance in the same manner as in the first embodiment.

The analysis unit 27 comprises the reverse-phase current/positive-phase current analysis unit 29, and analyzes the increase amount of the reverse-phase current value Isn relative to the positive-phase current Isp.

The determination unit 31 comprises the winding short-circuit determination unit 32 and the contact failure determination unit 33, and performs determination of a short-circuit and a contact failure on the basis of the analysis result by the reverse-phase current/positive-phase current analysis unit 29, and the reverse-phase current value, respectively.

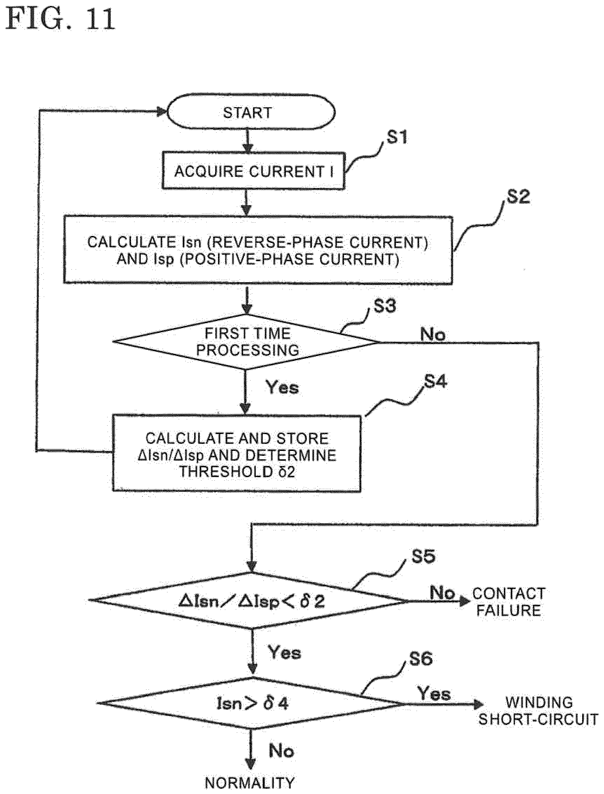

FIG. 11 is a flowchart illustrating a diagnosis processing according to the fourth embodiment. In FIG. 11, at step S1, the current I is acquired, and at step S2, the reverse-phase current Isn and the positive-phase current Isp are calculated. At step S3, first time determination is performed, and when the processing is the first time processing (YES), the processing proceeds to step S4.

At step S4, the increase amount of the reverse-phase current Isn relative to the positive-phase current Isp is calculated from the reverse-phase current/positive-phase current characteristic, and the threshold $\delta2$ is determined.

After that, the processing returns to START.

When steps S1 to S3 are performed and it is determined at step S3 that the processing is not a first time processing (NO), the processing proceeds to step S5. At step S5, the increase amount of the reverse-phase current Isn relative to the positive-phase current Isp is compared with the threshold $\delta 2$.

When the increase amount of the reverse-phase current Isn relative to the positive-phase current Isp is equal to or greater than the threshold $\delta 2$ (NO), a contact failure is determined. When the increase amount of the reverse-phase current Isn relative to the positive-phase current Isp is less than the threshold $\delta 2$ (YES), the processing proceeds to step S6. At step S6, the value of the reverse-phase current Isn is compared with a threshold $\delta 4$.

The threshold $\delta 4$ is set to a predetermined value through an actual test or the like. When the reverse-phase current Isn is equal to or greater than the threshold $\delta 4$ at step S6 (YES), a winding short-circuit is determined. When the reverse-phase current Isn is less than the threshold $\delta 4$ (NO), normality is determined.

As described above, the accuracy of detection in the fourth embodiment is lower than the accuracy of detection using a voltage and a current as in the first and second embodiments.

However, a winding short-circuit can be determined and detected using only currents, even when the load torque varies during operation of the electric motor. In addition, even when a contact failure occurs in the power source line, determination of a winding short-circuit in the electric motor can be performed.

The embodiments of the present invention have been described above.

DESCRIPTION OF THE REFERENCE CHARACTERS

| 1 | main circuit |
|---|---|
| 2 | wiring disconnector |
| 3 | electromagnetic contactor |
| 4 | instrument current transformer |
| 5 | instrument voltage transformer |
| 6 | electric motor |
| 7 | machinery facility |
| 8 | voltage detection circuit |
| 9 | current detection circuit |
| 10 | logical calculation circuit |
| 11 | storage circuit |
| 12 | setting circuit |
| 13 | display circuit |
| 14 | driving circuit |
| 15 | external output circuit |
| 21 | current voltage conversion unit |
| 21a | current conversion unit |
| 22 | reverse-phase current/reverse-phase voltage calculation unit |
| 22a | reverse-phase current calculation unit23 positive-phase current/positive-phase voltage calculation unit |
| 23a | positive-phase current calculation unit |
| 24 | initial analysis unit |
| 25 | reverse-phase admittance characteristic analysis unit |
| 26 | reverse-phase current/positive-phase current characteristic analysis unit |
| 27 | analysis unit |
| 28 | evaluation value analysis unit |
| 29 | reverse-phase current/positive-phase current analysis unit |
| 30 | voltage imbalance rate analysis unit |
| 31 | determination unit |
| 32 | winding short-circuit determination unit |
| 33 | contact failure determination unit |
| 34 | voltage imbalance determination unit |
| 100 | electric motor diagnosis device |

**Claims**

1.  An electric motor diagnosis device comprising:

    - a current detection circuit (9) configured to detect a current of an electric motor (6) on the basis of a current flowing through a main circuit (1) of a power source connected to the electric motor (6);
    - a voltage detection circuit (8) configured to detect a voltage of the electric motor (6) on the basis of a voltage of the main circuit (1) of the power source;
    - a logical calculation unit (10) which is adapted to receive outputs from the current detection circuit (9) and the voltage detection circuit (8), and to determine a winding short-circuit abnormality in the electric motor (6);
    - a display unit (13) configured to display, when the logical calculation unit (10) detects an abnormality in the electric motor (6), that the abnormality has occurred; and
    - an external output unit (15) configured to report, when the logical calculation unit (10) detects an abnormality in the electric motor (6), occurrence of the abnormality to an outside thereof, wherein the logical calculation unit (10) is adapted to determine a winding short-circuit abnormality by distinguishing, even when a load torque varies during operation of the electric motor (6), the winding short-circuit from power source imbalance on the basis of a reverse-phase current, a reverse-phase voltage, a positive-phase current, and a reverse-phase admittance which are obtained through analysis of the voltage and the current of the electric motor (6),

    **characterized in that**
    the logical calculation unit (10) is adapted to store a normal time reverse-phase admittance value before determination of the winding-short circuit, to determine the winding short-circuit abnormality independent of the load torque.

2.  The electric motor diagnosis device according to claim 1,
    wherein the logical calculation unit (10):

    comprises

    - an evaluation value analysis unit (28) configured to analyze an evaluation value obtained from the reverse-phase current, the reverse-phase voltage, and the reverse-phase admittance,
    - an analysis unit (29) configured to analyze the increase amounts of the reverse-phase current and the positive-phase current, and
    - an analysis unit (30) configured to analyze the voltage imbalance rate of the power source; and

    is adapted to determine the winding short-circuit in the electric motor (6) by distinguishing the winding short-circuit from a voltage imbalance in the power source and a contact failure.

3.  The electric motor diagnosis device according to claim 2,
    wherein the logical calculation unit (10) is adapted to store a positive-phase current characteristic of the reverse-phase admittance at a normal time before performing determination of the winding short-circuit, and to assign a reverse-phase admittance value of the positive-phase current in an evaluation value analysis performed by the evaluation value analysis unit (28).

4.  The electric motor diagnosis device according to claim 2 or 3,
    wherein the evaluation value analysis unit (28) of the logical calculation unit (10) is adapted to calculate an evaluation value

    $$A = |\text{reverse-phase current}$$
    $$- \text{reverse-phase admittance} * \text{reverse-phase voltage}|,$$

    and to determine the winding short-circuit in the electric motor (6) when the evaluation value A is greater than a predetermined threshold $\delta 1$.

5.  The electric motor diagnosis device according to any one of claims 2 to 4,
    wherein the analysis unit (29), of the logical calculation unit (10), configured to analyze the increase amounts of the reverse-phase current and the positive-phase current, is adapted to store an increase amount of reverse-phase current/positive-phase current characteristic at a normal time before performing determination, to determine a threshold δ2 by statistical processing, and to distinguish the winding short-circuit in the electric motor (6) from the contact failure depending on whether the increase amount of the reverse-phase current relative to the positive-phase current is greater or less than the threshold δ2.

6. The electric motor diagnosis device according to any one of claims 2 to 5,
wherein the analysis unit (30), of the logical calculation unit (10), configured to analyze the voltage imbalance rate, is adapted to determine a voltage imbalance when the voltage imbalance rate of the power source is greater than a predetermined value.

7. The electric motor diagnosis device according to any one of claims 1 to 6, wherein the logical calculation unit (10) is adapted to collectively perform abnormality determination on a plurality of the electric motors (6), and to determine abnormality in the electric motors (6).

**Patentansprüche**

1. Elektromotor-Diagnoseeinrichtung, die Folgendes aufweist:

   - eine Stromdetektionsschaltung (9), die so konfiguriert ist, dass sie auf der Basis eines Stroms, der durch eine Hauptschaltung (1) einer mit dem Elektromotor (6) verbundenen Stromquelle fließt, einen Strom eines Elektromotors (6) detektiert;
   - eine Spannungsdetektionsschaltung (8), die so konfiguriert ist, dass sie auf der Basis einer Spannung der Hauptschaltung (1) der Stromquelle eine Spannung des Elektromotors (6) detektiert;
   - eine Logik-Berechnungseinheit (10), die dafür ausgelegt ist, Ausgaben von der Stromdetektionsschaltung (9) und der Spannungsdetektionsschaltung (8) zu empfangen und eine Wicklungskurzschluss-Anomalie in dem Elektromotor (6) zu bestimmen;
   - eine Anzeigeeinheit (13), die so konfiguriert ist, dass sie, wenn die Logik-Berechnungseinheit (10) eine Anomalie in dem Elektromotor (6) detektiert, das Auftreten der Anomalie anzeigt; und
   - eine externe Ausgabeeinheit (15), die so konfiguriert ist, dass sie, wenn die Logik-Berechnungseinheit (10) eine Anomalie in dem Elektromotor (6) detektiert, das Auftreten der Anomalie nach außen meldet,

   wobei die Logik-Berechnungseinheit (10) dafür ausgelegt ist, eine Wicklungskurzschluss-Anomalie zu bestimmen, indem der Wicklungskurzschluss auf der Basis eines Umkehrphasenstroms, einer Umkehrphasenspannung, eines Positivphasenstroms sowie einer Umkehrphasen-Admittanz, die durch eine Analyse der Spannung und des Stroms des Elektromotors (6) erhalten werden, von einer Stromquellenschwankung unterschieden wird, auch wenn sich ein Lastmoment während des Betriebs des Elektromotors (6) ändert,
   **dadurch gekennzeichnet,**
   **dass** die Logik-Berechnungseinheit (10) dafür ausgelegt ist, einen Normalzeit-Umkehrphasen-Admittanzwert vor einer Bestimmung des Wicklungskurzschlusses zu speichern, um die Wicklungskurzschluss-Anomalie unabhängig von dem Lastmoment zu bestimmen.

2. Elektromotor-Diagnoseeinrichtung nach Anspruch 1,
   wobei die Logik-Berechnungseinheit (10) Folgendes aufweist:

   - eine Evaluierungswert-Analyseeinheit (28), die so konfiguriert ist, dass sie einen Evaluierungswert analysiert, der aus dem Umkehrphasenstrom, der Umkehrphasenspannung und der Umkehrphasen-Admittanz erhalten wird,
   - eine Analyseeinheit (29), die so konfiguriert ist, dass sie die Zunahmewerte des Umkehrphasenstroms und des Positivphasenstroms analysiert, und
   - eine Analyseeinheit (30), die so konfiguriert ist, dass sie die Spannungsschwankungsrate der Stromquelle analysiert;

   und die dafür ausgelegt ist, den Wicklungskurzschluss in dem Elektromotor (6) zu bestimmen, indem der Wicklungskurzschluss von einer Spannungsschwankung in der Stromquelle und eine Kontaktfehlfunktion unterschieden werden.

3. Elektromotor-Diagnoseeinrichtung nach Anspruch 2,
   wobei die Logik-Berechnungseinheit (10) dafür ausgelegt ist, eine Positivphasenstrom-Charakteristik der Umkehrphasen-Admittanz in Normalzeit zu speichern, bevor eine Bestimmung des Wicklungskurzschlusses durchgeführt wird, und einen Umkehrphasen-Admittanzwert des Positivphasenstroms in einer Evaluierungswert-Analyse zuzuordnen, die durch die Evaluierungswert-Analyseeinheit (28) durchgeführt wird.

**4.** Elektromotor-Diagnoseeinrichtung nach Anspruch 2 oder 3,
wobei die Evaluierungswert-Analyseeinheit (28) der Logik-Berechnungseinheit (10) dafür ausgelegt ist, einen Evaluierungswert

$$A = |\text{Umkehrphasenstrom}$$
$$- \text{Umkehrphasen-Admittanz} * \text{Umkehrphasenspannung}|$$

zu berechnen und den Wicklungskurzschluss in dem Elektromotor (6) zu bestimmen, wenn der Evaluierungswert A größer als ein vorgegebener Schwellenwert $\delta 1$ ist.

**5.** Elektromotor-Diagnoseeinrichtung nach einem der Ansprüche 2 bis 4, wobei die Analyseeinheit (29) der Logik-Berechnungseinheit (10), die so konfiguriert ist, dass sie die Zunahmewerte des Umkehrphasenstroms und des Positivphasenstroms analysiert, dafür ausgelegt ist, einen Zunahmewert einer Umkehrphasenstrom/Positivphasenstrom-Charakteristik in Normalzeit zu speichern, bevor eine Bestimmung durchgeführt wird, um einen Schwellenwert $\delta 2$ durch eine statistische Verarbeitung zu bestimmen, und den Wicklungskurzschluss in dem Elektromotor (6) von der Kontaktfehlfunktion in Abhängigkeit davon zu unterscheiden, ob der Zunahmewert des Umkehrphasenstroms relativ zu dem Positivphasenstrom größer oder kleiner als der Schwellenwert $\delta 2$ ist.

**6.** Elektromotor-Diagnoseeinrichtung nach einem der Ansprüche 2 bis 5, wobei die Analyseeinheit (30) der Logik-Berechnungseinheit (10), die so konfiguriert ist, dass sie die Spannungsschwankungsrate analysiert, dafür ausgelegt ist, eine Spannungsschwankung zu bestimmen, wenn die Spannungsschwankungsrate der Stromquelle größer als ein vorgegebener Wert ist.

**7.** Elektromotor-Diagnoseeinrichtung nach einem der Ansprüche 1 bis 6, wobei die Logik-Berechnungseinheit (10) dafür ausgelegt ist, kollektiv eine Anomalie-Bestimmung bei einer Mehrzahl der Elektromotoren (6) durchzuführen und eine Anomalie in den Elektromotoren (6) zu bestimmen.

**Revendications**

**1.** Dispositif de diagnostic de moteur électrique comprenant :

- un circuit de détection de courant (9) configuré pour détecter un courant d'un moteur électrique (6) sur la base d'un courant s'écoulant à travers un circuit principal (1) d'une source de puissance connectée au moteur électrique (6) ;
- un circuit de détection de tension (8) configuré pour détecter une tension du moteur électrique (6) sur la base d'une tension du circuit principal (1) de la source de puissance ;
- une unité de calcul logique (10) qui est adaptée pour recevoir des sorties provenant du circuit de détection de courant (9) et du circuit de détection de tension (8), et pour déterminer une anomalie de court-circuit de bobinage dans le moteur électrique (6) ;
- une unité d'affichage (13) configurée pour afficher, quand l'unité de calcul logique (10) détecte une anomalie dans le moteur électrique (6), que l'anomalie s'est produite ; et
- une unité de sortie externe (15) configurée pour rendre compte, quand l'unité de calcul logique (10) détecte une anomalie dans le moteur électrique (6), d'une apparition de l'anomalie vers l'extérieur,

dans lequel l'unité de calcul logique (10) est adaptée pour déterminer une anomalie de court-circuit de bobinage en distinguant, même si un couple de charge varie durant un fonctionnement du moteur électrique (6), le court-circuit de bobinage d'un déséquilibre de source de puissance sur la base d'un courant de phase inverse, d'une tension de phase inverse, d'un courant de phase positive et d'une admittance de phase inverse qui sont obtenus au moyen d'une analyse de la tension et du courant du moteur électrique (6), **caractérisé en ce que**
l'unité de calcul logique (10) est adaptée pour stocker une valeur d'admittance de phase inverse en temps normal avant la détermination du court-circuit de bobinage, pour déterminer l'anomalie de court-circuit de bobinage indépendamment du couple de charge.

2. Dispositif de diagnostic de moteur électrique selon la revendication 1, dans lequel l'unité de calcul logique (10) comprend :

- une unité d'analyse de valeur d'évaluation (28) configurée pour analyser une valeur d'évaluation obtenue à partir du courant de phase inverse, de la tension de phase inverse et de l'admittance de phase inverse,
- une unité d'analyse (29) configurée pour analyser les amplitudes d'augmentation du courant de phase inverse et du courant de phase positive, et
- une unité d'analyse (30) configurée pour analyser le taux de déséquilibre de tension de la source de puissance ; et

est adaptée pour déterminer le court-circuit de bobinage dans le moteur électrique (6) en distinguant le court-circuit de bobinage d'un déséquilibre de tension dans la source de puissance et d'une défaillance de contact.

3. Dispositif de diagnostic de moteur électrique selon la revendication 2, dans lequel l'unité de calcul logique (10) est adaptée pour stocker une caractéristique de courant de phase positive de l'admittance de phase inverse à un temps normal avant d'effectuer une détermination du court-circuit de bobinage, et pour attribuer une valeur d'admittance de phase inverse du courant de phase positive dans une analyse de valeur d'évaluation effectuée par l'unité d'analyse de valeur d'évaluation (28).

4. Dispositif de diagnostic de moteur électrique selon la revendication 2 ou 3, dans lequel l'unité d'analyse de valeur d'évaluation (28) de l'unité de calcul logique (10) est adaptée pour calculer une valeur d'évaluation

$$A = | \text{ courant de phase inverse}$$
$$- \text{ admittance de phase inverse} * \text{tension de phase inverse} |,$$

et pour déterminer le court-circuit de bobinage dans le moteur électrique (6) quand la valeur d'évaluation A est supérieure à un seuil prédéterminé $\delta 1$.

5. Dispositif de diagnostic de moteur électrique

selon l'une quelconque des revendications 2 à 4,
dans lequel l'unité d'analyse (29), de l'unité de calcul logique (10), configurée pour analyser les amplitudes d'augmentation du courant de phase inverse et du courant de phase positive, est adaptée pour stocker une amplitude d'augmentation d'une caractéristique de courant de phase inverse/courant de phase positive à un temps normal avant d'effectuer une détermination, pour déterminer un seuil $\delta 2$ par un traitement statistique, et pour distinguer le court-circuit de bobinage dans le courant électrique (6) de la défaillance de contact selon que l'amplitude d'augmentation du courant de phase inverse relativement au courant de phase positive est supérieure ou inférieure au seuil $\delta 2$.

6. Dispositif de diagnostic de moteur électrique

selon l'une quelconque des revendications 2 à 5,
dans lequel l'unité d'analyse (30), de l'unité de calcul logique (10), configurée pour analyser le taux de déséquilibre de tension, est adaptée pour déterminer un déséquilibre de tension quand le taux de déséquilibre de tension de la source de puissance est supérieur à une valeur prédéterminée.

7. Dispositif de diagnostic de moteur électrique

selon l'une quelconque des revendications 1 à 6,
dans lequel l'unité de calcul logique (10) est adaptée pour effectuer collectivement une détermination d'anomalie sur une pluralité de moteurs électriques (6), et pour déterminer une anomalie dans les moteurs électriques (6).

# FIG. 1

# FIG. 2

$$\mu = \frac{N_f}{N}$$

# FIG. 3

**10** LOGICAL CALCULATION UNIT

**21** CURRENT VOLTAGE CONVERSION UNIT

**22** REVERSE-PHASE CURRENT/VOLTAGE CALCULATION

**23** POSITIVE-PHASE CURRENT/VOLTAGE CALCULATION

**24** INITIAL ANALYSIS UNIT

**25** REVERSE-PHASE ADMITTANCE CHARACTERISTIC ANALYSIS

**26** REVERSE-PHASE CURRENT/POSITIVE-PHASE CURRENT CHARACTERISTIC ANALYSIS

**27** ANALYSIS UNIT

**28** EVALUATION VALUE ANALYSIS

**29** REVERSE-PHASE CURRENT/POSITIVE-PHASE CURRENT ANALYSIS

**30** VOLTAGE IMBALANCE RATE ANALYSIS

**31** DETERMINATION UNIT

**32** WINDING SHORT-CIRCUIT DETERMINATION

**33** CONTACT FAILURE DETERMINATION

**34** VOLTAGE IMBALANCE DETERMINATION

# FIG. 4

$Y_{42}$

$Y_{41}$

REVERSE-PHASE ADMITTANCE $Y_n[S]$

OFF-LOAD CURRENT   RATED CURRENT

POSITIVE-PHASE CURRENT $I_{sp}[A]$

FIG. 5

FIG. 6

EP 3 232 215 B1

# FIG. 7

START

S1 — ACQUIRE V AND I

S2 — CALCULATE Isn (REVERSE-PHASE CURRENT), Vsn (REVERSE-PHASE VOLTAGE), Isp (POSITIVE-PHASE CURRENT), Vunbal (VOLTAGE IMBALANCE RATE), AND POWER SUPPLY VOLTAGE Vs

S3 — FIRST TIME PROCESSING — No / Yes

S4 — STORE POWER SOURCE VOLTAGE

S5 — CALCULATE AND STORE Yn=Isn/Vsn

S6 — CALCULATE AND STORE ΔIsn/ΔIsp AND DETERMINE THRESHOLD δ2

S7 — Vunbal<5% — Yes / No → VOLTAGE IMBALANCE

S8 — A=|Isn−YnVsn|>δ1 — Yes / No

S9 — ΔIsn/ΔIsp<δ2 — Yes → WINDING SHORT-CIRCUIT / No → CONTACT FAILURE

S10 — ΔIsn/ΔIsp<δ2 — Yes → NORMALITY / No

S11 — A=|Isn−YnVsn|>δ3 (WHEN Isp=0) — Yes → WINDING SHORT-CIRCUIT / No → CONTACT FAILURE

# FIG. 8

```
                    ┌──────────────┐
                    │    START     │
                    └──────┬───────┘
                           │           S1
                    ┌──────┴───────┐
                    │ ACQUIRE V AND I │
                    └──────┬───────┘
                           │                          S2
        ┌──────────────────┴──────────────────────┐
        │ CALCULATE Isn (REVERSE-PHASE CURRENT),   │
        │      Vsn (REVERSE-PHASE VOLTAGE),         │
        │     Isp (POSITIVE-PHASE CURRENT),         │
        │ Vunbal (VOLTAGE IMBALANCE RATE), AND      │
        │      POWER SUPPLY VOLTAGE Vs              │
        └──────────────────┬──────────────────────┘
                           │            S3
                    ╱──────┴──────╲          No
                   ╱  FIRST TIME   ╲──────────────┐
                   ╲  PROCESSING   ╱              │
                    ╲──────┬──────╱               │
                      Yes  │                      │
                    ┌──────┴───────┐  S4          │
                    │ STORE POWER   │             │
                    │ SOURCE VOLTAGE │            │
                    └──────┬───────┘              │
                           │            S5        │
                    ┌──────┴───────┐              │
                    │ CALCULATE AND │             │
                    │ STORE Yn=Isn/Vsn │          │
                    └──────┬───────┘              │
                           │            S6        │
              ┌────────────┴──────────────┐       │
              │ CALCULATE AND STORE        │       │
              │ ΔIsn/ΔIsp AND DETERMINE     │       │
              │ THRESHOLD δ2                │       │
              └────────────┬──────────────┘       │
                           └──────────────────────┘
```

$Yn = Isn/Vsn$

CALCULATE AND STORE $\Delta Isn/\Delta Isp$ AND DETERMINE THRESHOLD $\delta 2$

S7 — $Vunbal < 5\%$ — Yes → S8 — $\Delta Isn / \Delta Isp < \delta 2$ — No

No ↓

VOLTAGE IMBALANCE

S8 Yes ↓

S9 — $A = | Isn - YnVsn | > \delta 1$ — Yes → WINDING SHORT-CIRCUIT

No ↓

NORMALITY

S10 — $A = | Isn - YnVsn | > \delta 3$ (WHEN $Isp=0$) — Yes → WINDING SHORT-CIRCUIT

No ↓

CONTACT FAILURE

## FIG. 9

## FIG. 10

FIG. 11

```
                    ┌─────────────┐
                    │    START    │
                    └──────┬──────┘
                           │                    S1
                    ┌──────┴──────┐
                    │ACQUIRE CURRENT I│
                    └──────┬──────┘
                           │                              S2
        ┌──────────────────┴──────────────────┐
        │ CALCULATE Isn (REVERSE-PHASE CURRENT)│
        │  AND Isp (POSITIVE-PHASE CURRENT)    │
        └──────────────────┬──────────────────┘
                           │              S3
                    ◇ FIRST TIME ◇─── No
                    ◇ PROCESSING ◇
                           │ Yes          S4
        ┌──────────────────┴──────────────────┐
        │   CALCULATE AND STORE                │
        │ ΔIsn/ΔIsp AND DETERMINE              │
        │   THRESHOLD δ2                        │
        └──────────────────┬──────────────────┘
                           │          S5
                    ◇ ΔIsn／ΔIsp＜δ2 ◇── No → CONTACT
                           │ Yes                  FAILURE
                           │          S6
                    ◇ Isn＞δ4 ◇──── Yes → WINDING
                           │ No              SHORT-CIRCUIT
                      NORMALITY
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014156386 A1
- US 5477163 A
- JP 62218883 A
- JP 2012220485 A
- JP 4367784 B